# EUROPÄISCHE PATENTSCHRIFT

(11) **EP 2 027 762 B1**
(45) Veröffentlichungstag und Bekanntmachung des Hinweises auf die Patenterteilung: **26.01.2011**
(21) Anmeldenummer: 07729383.5
(22) Anmeldetag: 22.05.2007
(51) Int. Cl.: H05K 9/00, H01L 23/057, H01L 23/552, H01L 23/66

(54) **ELEKTRISCHE EINRICHTUNG MIT ABSCHIRMUNG**
ELECTRICAL DEVICE WITH SCREEN
DISPOSITIF ÉLECTRIQUE AVEC BLINDAGE

(30) Priorität: 23.05.2006 DE 102006024551
(43) Veröffentlichungstag der Anmeldung: 25.02.2009
(73) Patentinhaber: Continental Automotive GmbH, 30165 Hannover (DE)
(72) Erfinder: KÖHLER, Stefan, 60437 Frankfurt (DE); WIESE, Peter, 65779 Kelkheim (DE)
(86) Internationale Anmeldenummer: PCT/EP2007/054944
(87) Internationale Veröffentlichungsnummer: WO 2007/135148

(56) Entgegenhaltungen:
- EP-A1- 0 429 037
- EP-A1- 0 805 619
- WO-A-2005/029937
- US-A- 5 491 301

## Beschreibung

Die vorliegende Erfindung befasst sich mit einer elektronischen Einrichtung mit einer Abschirmung gegen hochfrequente elektromagnetische Felder, wobei die Abschirmung aus einer die Einrichtung umgebenden, wenigstens teilweise leitfähigen Kappe besteht, wobei leitfähige flächige Bereiche der Kappe elektrisch isoliert in geringem Abstand parallel zu einem flächigen Bereich eines Leiters eines Bezugspotentials angeordnet sind, so dass eine kapazitive Kopplung der Kappe an das Bezugspotential entsteht.

Bei elektronischen Einrichtungen, die komplette Schaltungen oder nur einzelne Bauelemente umfassen, beispielsweise elektronischen Sensoren, besteht je nach Anwendungsfall das Problem, dass hochfrequente elektromagnetische Störfelder zu einer Signalbeeinflussung führen können, die die Funktion der elektronischen Einrichtung stören. Umgekehrt kann auch die elektronische Einrichtung selbst die Ursache für hochfrequente elektromagnetische Felder sein, die mit Hilfe der Kappe abgeschirmt werden sollen, um beispielsweise eine Störung umliegender elektronischer Bauelemente oder des Rundfunkempfangs in der Umgebung zu vermeiden.

Bekannt ist es, wenigstens teilweise leitfähige Gehäuse nach dem Prinzip des Faradayschen Käfigs einzusetzen, um ohne weiteres statische elektrische Felder abzuschirmen. Bei hochfrequenten elektromagnetischen Feldern ist es nicht hinreichend, die abgeschirmten Bauteile mit Leitern zu umgeben, sondern diese müssen zum Erreichen einer wirksamen Abschirmung mit einem Bezugspotential elektrisch verbunden werden. Ansonsten kann es im schlimmsten Fall dazu kommen, dass die Abschirmung selbst in der Funktion einer Antenne hochfrequente Energie ein- oder auskoppelt und damit das Störproblem noch verschlimmert.

Im einfachsten Fall genügt hierbei eine so genannte galvanische Erdung der Abschirmung an einem Bezugspotential, wobei bei Wechselspannungen in der Regel ein beliebiges Potential gewählt werden kann, um die gewünschte Abschirmung zu erreichen.

Für Anwendungsfälle, in denen eine direkte galvanische Erdung des Gehäuses unzulässig ist, beispielsweise für die Schirmgehäuse von Steuergeräten im Automobilbereich, erfolgt die Kopplung auch kapazitiv durch eine üblich Kombination aus einem Widerstand mit einem parallel angeordneten Kondensator, die als diskrete Bauteile mit bestimmten Kennwerten für den Widerstand und die Kapazität ausgeführt sind.

Damit ergibt sich bei allen bekannten Lösungen das Problem, dass bei einem Gehäuse oder einer Kappe als Abschirmung immer eine unmittelbare elektrische Verbindung zu dem Bezugspotential hergestellt werden muss, was immer einen zusätzlichen Aufwand bedeutet. Die elektrische Verbindung muss auch dauerhaft ausgeführt sein, so dass es beispielsweise im Automobilbereich auch nach langjähriger Nutzung nicht zu einer Unterbrechung der elektrischen Verbindung und damit zu einem Ausfall der Schirmwirkung kommen kann.

Besondere Schwierigkeiten im Einsatz leitfähiger Kappen bestehen auch dann, wenn beispielsweise nur ein bestimmtes Bauteil abgeschirmt werden soll, das auf einer Leiterplatte oder Leitern eines so genannten Leadframes angeordnet ist, bei welchem metallische Stanz- oder Blechelemente von einem Kunststoffträger gehalten sind. Da hier in der Regel mehrere Leiter mit unterschiedlichen Potentialen in der Leiterplatten- oder Leadframeebene angeordnet sind, kann es durch unvorsichtiges Anordnen einer leitfähigen Kappe schnell zu einer Gefahr von Kurzschlüssen kommen.

Eine elektronische Einrichtung der eingangs genannten Art ist aus der US 5, 4991,301 A bekannt. Diese Lösung bietet den Vorteil, dass die Kappe mit wenigstens einem ohnehin vorgesehenen Leiter quasi einen Kondensator bildet, d. h. durch die enge, elektrisch isolierte Anordnung der flächigen Bereiche der Kappe zu einem flächigen Bereich eines Leiters eines Bezugspotentials entsteht die selbe Wirkung, die ein Kondensator entsprechender Kapazität hätte, der als diskretes Bauteil mit dem Leiter einerseits und der Kappe andererseits elektrisch verbunden wäre. Da aber bei dieser Lösung keinerlei Anschlussdrähte zwischen der Kappe und dem Leiter erforderlich sind, ist die geschaffene kapazitive Kopplung extrem induktivitätsarm, so dass die Abschirmwirkung bis in den Gigahertzbereich hinein gegeben ist. Weitere Abschirmeinrichtungen zeigen die EP 0 429 037 A1, die EP 805 619 A1 und die WO2005/029937 A.

Die Aufgabe der vorliegenden Erfindung besteht darin, ein elektronisches Bauteil mit einer Abschirmung zu versehen, die ohne großen Aufwand eine dauerhafte Ein- oder Ausstrahlung hochfrequenter elektromagnetischer Felder verhindert.

Erfindungsgemäß wird die Aufgabe durch eine elektronische Einrichtung der eingangs genannten Art gelöst, bei welcher die flächigen Bereiche der Kappe mit flächigen Bereichen verschiedener Leiter mit unterschiedlichen Bezugspotentialen zusammenwirken.

Bei der Lösung dieser Aufgabe durch die Erfindung wirken die flächigen Bereiche der Kappe mit flächigen Bereichen verschiedener Leiter mit unterschiedlichen Bezugspotentialen zursammen. Auf diese Weise ist es möglich, die flächigen Bereiche mehrerer Leiter bzw. auf einer Leiterplatte bei einer Leadframekonstruktion auszunutzen, da sich die Einzelkapazitäten, die durch die jeweiligen flächigen Bereiche erzeugt werden, addieren, so dass insgesamt eine kapazitive Kopplung mit einer höheren Kapazität erreicht wird. Die erfindungsgemäße Lösung eignet sich in gleicher Weise für die Abschirmung komplexer Baugruppen, die hier ebenfalls unter dem Begriff Einrichtung verstanden werden sollen, wie einzelner Bauteile, wie z. B. Sensoren, die auf einer Leiterplatte oder dem bereits angesprochenen Leadframe angeordnet sind. Da zur kapazitiven Anbindung ohnehin eine Isolationsschicht zwischen den leitfähigen flächigen Bereichen der Kappe und den flächigen Bereichen des Leiters notwendig ist, besteht auch kein Problem darin, dass die aufgesetzte Kappe die Zuleitung der elektrischen Einrichtung kurzschließen könnte.

Für die elektrische Isolierung zwischen den flächigen Bereichen, die die kapazitive Kopplung bilden, eignen sich grundsätzlich alle elektrisch isolierenden Materialien. Im einfachsten Fall würde bereits ein Luftspalt die gewünschte Kapazität erzeugen, wobei ein Luftspalt allerdings wegen der Gefahr von Spannungsüberschlägen bei den zur Erzielung einer möglichst großen Kapazität gewünschten niedrigen Abständen weniger geeignet ist und die Gefahr eines Zusetzens des Luftspaltes mit leitfähigem Schmutz bestünde, der dann wiederum mehrere Leiter über die leitfähige Kappe kurzschließen könnte. Bewährt haben sich dünne, isolierende Folien aus beispielsweise Polyimid, wobei sich auch nicht leitfähige Beschichtungen zwischen den flächigen Bereichen als zweckmäßig erwiesen haben, wobei die nicht leitfähigen Beschichtungen an der Kappe und/oder den flächigen Bereichen der Leiter vorgesehen sein können.

Eine bevorzugte Ausführungsform der Erfindung sieht vor, dass die flächigen Bereiche der Kappe an einem stirnseitigen Randbereich der Kappe ausgebildet sind, die senkrecht auf dem flächigen Leiter des wenigstens einen Bezugspotentials steht. Eine solche Ausbildung erlaubt die Verwendung länglicher Kappen, beispielsweise in der Form eines gegenüber des flächigen Bereichs geschlossenen Zylinders, so dass das elektronische Bauteil tief in der Kappe angeordnet werden kann und die Gefahr der Einstrahlung durch den offenen Bereich der Kappe innerhalb des stirnseitigen Randbereiches minimiert ist.

Zur leitfähigen Ausbildung der Kappe kann im einfachsten Fall vorgesehen sein, dass diese aus Metall besteht, wobei aber auch Ausführungsformen aus Kunststoff möglich sind, dem Metall- oder Kohlefasern zum Erreichen der Leitfähigkeit zugesetzt sind. In gleicher Weise sind leitfähige Beschichtungen auf der Innen- und/oder Außenseite der Kappe zum Erreichen der Leitfähigkeit möglich, wobei beispielsweise das Aufbringen einer metallischen Beschichtung durch Aufdampfen oder Sputtern oder das Aufbringen eines leitfähigen Lackes oder einer Graphitschicht zu nennen wären.

In einer weiteren bevorzugten Ausführungsform der Erfindung ist vorgesehen, dass zwischen der leitfähigen Kappe und dem Leiter eines bestimmten Bezugspotentials eine galvanische Verbindung vorgesehen ist. Eine solche galvanische Verbindung, die grundsätzlich auch die Abschirmung hochfrequenter elektromagnetischer Felder begünstigt, bietet insbesondere bei Kappen mit leitfähigen Oberflächen den Vorteil, dass bei einer unter Umständen unbeabsichtigt eingeleiteten höheren Spannung in die Kappe, beispielsweise durch einen Spannungsüberschlag, eine kontrollierte niederohmige Verbindung vorgesehen ist, über die das Spannungspotential abgebaut werden kann, während es beim Fehlen einer niederohmigen Verbindung zu einem Durchschlagen der Isolationsschicht an einer unerwünschten Stelle kommen könnte. Da die galvanische Verbindung bei der vorliegenden Erfindung für die Hochfrequenzabschirmung nicht notwenig ist, sind an ihre Kontaktierung auch nicht die sonst üblichen hohen Anforderungen zu stellen, so dass beispielsweise ein einfacher Berührungskontakt ausreicht. Dieser kann beispielsweise dadurch realisiert sein, dass die galvanische Verbindung durch einen an der Kappe oder dem Leiter des Bezugspotentials angeordneten leitfähigen Vorsprung ausgebildet ist, der durch die elektrische Isolierung ragt. Es versteht sich, dass eine solche galvanische Verbindung nur zu einem einzigen Bezugspotential hergestellt werden darf.

Wie bereits erwähnt, können die Leiter auf einer Leiterplatte angeordnet sein oder als massive Schienen- oder Blechelemente zusammen mit einem Kunststoffträger einen Leadframe bilden, wobei die Anordnung der Leiter dann in der Regel sternförmig zu dem Bauteil vorgesehen ist, das durch die Kappe abgeschirmt ist, so dass der stirnförmige Randbereich der Kappe auf die flächigen Oberflächen der Leiter aufgesetzt werden kann. Bei einem Leadframe kann die elektrische Isolierung zwischen den flächigen Bereichen auch dadurch hergestellt werden, dass der in Richtung der Kappe überstehende Kunststoff durch Warmumlegen die Isolierschicht bildet.

Die erfindungsgemäße Abschirmung kann beispielsweise bei einem permanentmagnetischen Sensor als elektronischem Bauteil eingesetzt werden, der die Stellung einer Welle erfasst.

Sofern nur relativ kleine flächige Bereiche für den Aufbau der Koppelkapazität zur Verfügung stehen, kann diese durch eine Verringerung des Abstandes der flächigen Bereiche zueinander oder auch durch Verwendung von Isolatoren mit einer relativen Dielektrizitätskonstanten größer als eins erhöht werden.

Nachfolgend wird anhand der beigefügten Zeichnungen näher auf ein Ausführungsbeispiel der Erfindung eingegangen. Es zeigen:
- Fig. 1: einen Längsschnitt durch eine elektronische Ein- richtung mit einer Abschirmung;
- Fig. 2: eine Stirnansicht der abgenommenen Abschirmung aus Fig. 1;
- Fig. 3: eine Draufsicht auf die Anschlussleiter der elekt- ronischen Einrichtung aus Fig. 1 bei abgenommener Abschirmung;

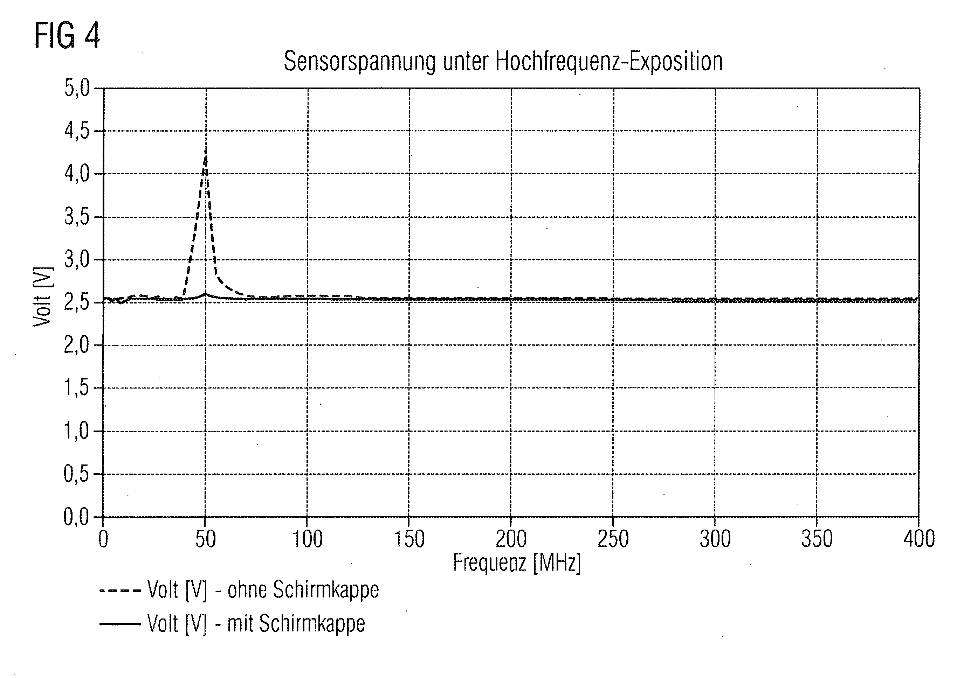

- Fig. 4: ein Schaubild der Sensorspannung des Sensors gemäß Fig. 4 über die Frequenz hochfrequenter Störein- strahlungen.

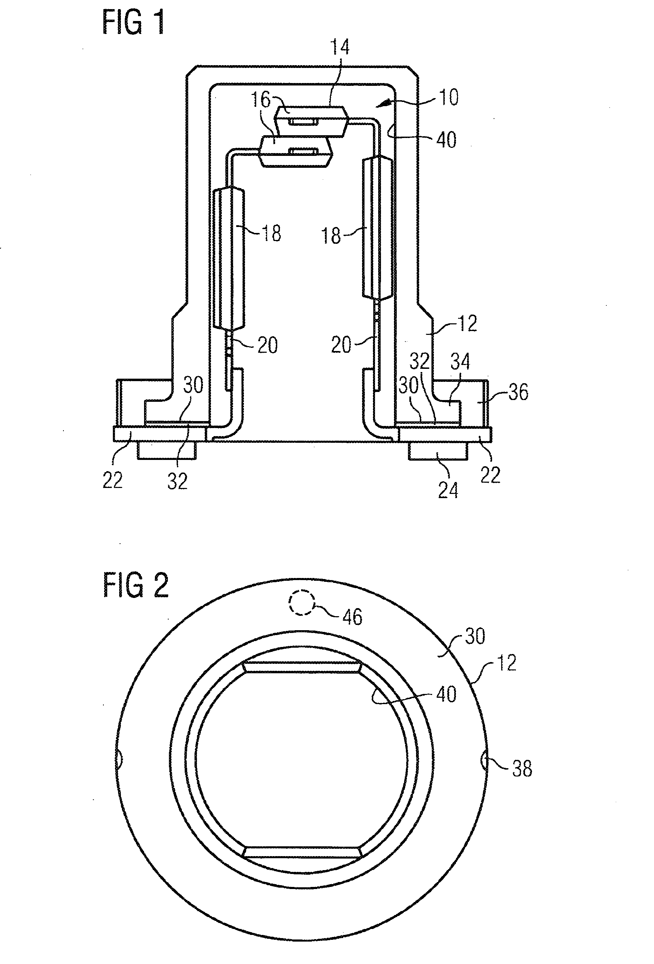

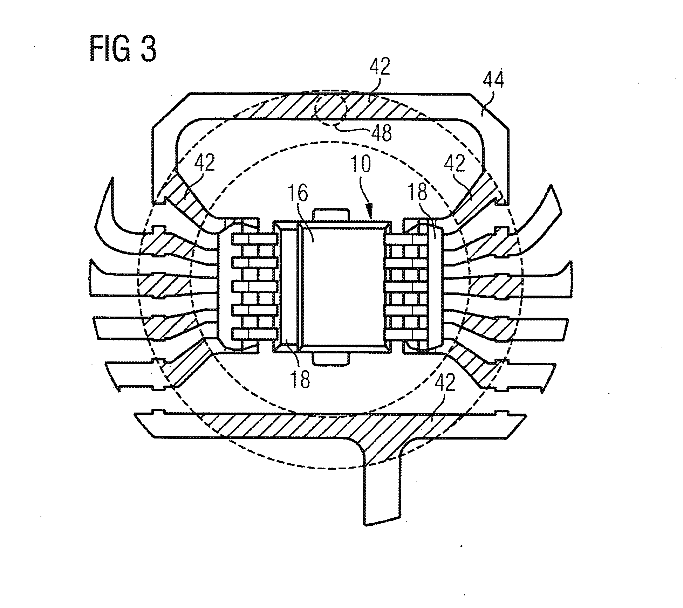

In Fig. 1 ist eine elektronische Einrichtung 10 gezeigt, die von einer Abschirmung 12 in Form einer Kappe umgeben ist. Die elektronische Einrichtung 10 besteht aus zwei redundant angeordneten Winkelgebern 14, die jeweils aus einem permanentmagnetischen Sensor 16 und einer jeweils zugeordneten Steuerelektronik 18 bestehen. Die beiden Steuerelektroniken 18 sind über Kontaktfahnen 20 mit Leitern 22 verbunden, die gemeinsam mit einem isolierenden Kunststoffträger 24 einen so genannten Leadframe bilden (siehe auch Fig. 3).

Die Kappe 12 ist becherförmig ausgebildet und über die elektronische Einrichtung 10 gestülpt, wobei sie an ihrer offenen Seite stirnseitig über einen ringförmigen Anlagebereich 30 über eine zwischenliegende elektrische Isolierung 32 auf den Leitern 22 abgestützt ist. Die stirnförmige Ringfläche verfügt über einen ringförmig nach außen vorspringenden Außenflansch 34, der von einer ringförmigen Kunststoffmasse 36 umspritzt und damit auf dem Leadframe gehalten ist.

Die Kappe 12 besteht aus einem leitfähigen Material, das hier als Kunststoff mit elektrisch leitenden Zusätzen, wie z. B. Kohle- oder Metallfasern ausgebildet ist. Es sind aber auch Ausführungsformen möglich, bei denen die Kappe 12 aus einem nichtleitenden Kunststoff besteht und im Bereich der Ringanlagefläche 30 sowie innenseitig und/oder außenseitig mit einem elektrisch leitfähigen Überzug versehen ist. Wie aus Fig. 2 zu erkennen ist, sind in der Außenflanke des ringförmigen Anlagebereichs 30 Einkerbungen 38 vorgesehen, die ein Montieren der Kappe nur in einer bestimmten Winkellage zu der elektronischen Einrichtung 10 ermöglichen. Aus Fig. 2 ist weiterhin ersichtlich, dass die Kappe einen Innenquerschnitt 40 besitzt, der von der Kreisform abweicht, um die abzuschirmenden Bauelemente möglichst eng anliegend zu umfassen.

Die bereits angesprochene elektrische Isolierung 32 kann beispielsweise aus einer dünnen isolierenden Folie, wie z. B. Polyimid oder Kapton (eingetragene Marke) bestehen, die vor dem Umspritzen der Kappe 12 mit dem Kunststoffmaterial 36 zwischen die ringförmige Anlagefläche 30 und die Leiterbahnen 22 gelegt wird. Zur Isolierung sind aber auch sonstige nichtleitende Beschichtungen möglich, wobei die Isolierschicht auch durch den Kunststoffträger 24 des Leadframes gebildet sein kann, indem nach oben über die Leitbahnen 22 überstehende Kunststoffteile im Wege des Warmumlegens flächig über die Oberflächen der Leiter verteilt werden.

Bedingt durch die flächenparallele Anordnung der leitfähigen stirnseitigen ringförmigen Anlagefläche 30 der Kappe 12 zu flächigen Bereichen 42 der Leiter 22 entsteht eine kapazitive Ankopplung der Kappe 12 an die Leiter 22, wobei sich die durch die Einzelflächen 42 ergebenden Einzelkapazitäten zu einer höheren Gesamtkapazität addieren, die wirksam hochfrequente elektromagnetische Felder abschirmt, so dass diese nicht in die elektronische Einrichtung 10 einstrahlen können und damit dass Messergebnis der Sensoren 16 verfälschen können. Am Beispiel von Fig. 5 ist zu erkennen, dass bei einem Versuchsaufbau ähnlich Fig. 1 ohne Abschirmung zunächst im Bereich einer Störfrequenz von 50 MHz eine erhebliche Abweichung der Sensorspannung generiert wurde, die nach Ausbildung der kapazitiven Anbindung in der zuvor beschriebenen Art und Weise nahezu vollständig eliminiert werden konnte.

Die Kapazität lässt sich beispielsweise durch eine Vergrößerung der ringförmigen Anlagefläche 30 erhöhen, sofern dadurch weitere flächige Bereiche der Leiter 22 in engem Abstand abgedeckt werden können. Eine zusätzliche Erhöhung der Kapazität für die kapazitive Kopplung kann durch ein nahes Heranrücken leitender Bereiche der Steuerelektroniken 18 oder ihrer Zuleitung an leitfähige Bereiche der Innenwandung 40 der Kappe 12 erreicht werden.

Neben der kapazitiven Ankopplung, die ohne weitere elektrische Kontaktierung zwischen der Kappe 12 und den Leitern 22 erreicht wird, kann auch eine zusätzliche galvanische Anbindung der leitfähigen Kopplung 12 an ein einziges Bezugspotential, hier den Leiter 44, vorgesehen sein, indem beispielsweise an einer Stelle der Ringfläche 30 ein punktförmiger leitfähiger Vorsprung 46 vorgesehen ist, der ungefähr die Höhe der Isolationsschicht zwischen der leitfähigen ringförmigen Anlagefläche der Kappe 12 und den Leitern 22 besitzt. Der Vorsprung 46 durchstößt die Isolation 32 und gelangt daher in galvanische Verbindung mit dem Leiter 44 (siehe Fig.2 bei 48). Dadurch ist es möglich, ein eventuell in die Kappe 12 eingeleitetes höheres Spannungspotential abzuleiten, ohne dass es zu einem unkontrollierten Überschlagen auf nicht näher definierte andere Leiter 22 kommen kann. Selbstverständlich ist darauf zu achten, dass eine solche galvanische Verbindung nur zu einen einzigen Leiter 22 hergestellt wird, um eine Kurzschlussbildung zu vermeiden.

Die erreichten Kapazitäten der kapazitiven Ankupplung der Kappe 12 über ihre ringförmige Anlagefläche an bestimmte Oberflächenbereiche 42 der Leiter 22 lagen selbst bei einfachsten, mäßig leitfähigen Überzügen der Kappe 12 und einer einfachen Isolierfolie zwischen den leitfähigen Flächen im Bereich von für die Schirmung bereits hinreichenden 10 pF, konnten aber durch besser leitfähige metallische Überzüge und eine Minimierung der Schichtdicke der elektrischen Isolation 32 leicht erhöht werden. Möglich ist auch der Einsatz von Isolatoren mit einer relativen Dielektrizitätskonstanten gröβer als 1, um die Kapazität weiter zu erhöhen, beispielsweise wenn für die ringförmige Anlagefläche nur sehr wenig Raum zur Verfügung steht oder die Leiter 22 an der Oberseite des Leadframes oder einer Leiterplatte nur relativ kleinflächig ausgeführt sind.

Neben dem gezeigten Anwendungsfall zur Abschirmung eines permanentmagnetischen Positionssensors lässt sich die beschriebene Abschirmung auch bei anderen elektronischen Einrichtungen wirksam einsetzen, die entweder empfindlich auf hochfrequente Störeinstrahlungen reagieren oder ihrerseits hochfrequente elektromagnetische Felder erzeugen, die umliegende elektronische Bauelemente oder auch den Funk- und Fernsehempfang stören könnten. Die Kappe 12 kann beispielsweise auch als ein Gehäuse ausgebildet sein, das eine komplette elektronische Baugruppe einschließlich mehrerer Leiterplatten oder dergleichen aufnimmt, besonders vorteilhaft ist aber, dass sie als kleine Kappe auch einzelne Einrichtungen und sogar einzelne Bauelemente auf einer Leiterplatte oder einem Leadframe abschirmen kann. So kann sie beispielsweise dort aufwändig abgeschirmte Gehäuse mit zusätzlichen RC-Gliedern vermeiden helfen, wo es letztlich genügt, ein einzelnes störempfindliches Bauteil abzuschirmen.

## Patentansprüche

1. Elektronische Einrichtung (10) mit einer Abschirmung (12) gegen hochfrequente elektromagnetische Felder, wobei die Abschirmung (12) aus einer die Einrichtung (10) umgebenden, wenigstens teilweise leitfähigen Kappe (12) besteht, wobei leitfähige flächige Bereiche (30) der Kappe elektrisch isoliert in geringem Abstand parallel zu einem flächigen Bereich (42) eines Leiters (22, 44) eines Bezugspotentials angeordnet sind, so dass eine kapazitive Kopplung der Kappe (12) an das Bezugspotential entsteht,
**dadurch gekennzeichnet dass** die flächigen Bereiche (30) der Kappe mit flächigen Bereichen (42) verschiedener Leiter mit unterschiedlichen Bezugspotentialen zusammenwirken.

2. Elektronische Einrichtung nach Anspruch 1, **dadurch gekennzeichnet, dass** die elektrische Isolierung (32) zwischen den flächigen Bereichen (30, 42) durch eine eingelegte Folie gebildet ist.

3. Elektronische Einrichtung nach Anspruch 1, **dadurch gekennzeichnet, dass** die elektrische Isolierung (32) durch eine nichtleitfähige Beschichtung der flächigen Bereiche (30) der Kappe (12) und/oder der flächigen Bereiche (42) zugeordneter Leiter (22) gebildet ist.

4. Elektronische Einrichtung nach einem der vorhergehenden Ansprüche, **dadurch gekennzeichnet, dass** die flächigen Bereiche (30) der Kappe (12) an einem stirnseitigen Randbereich (30) der Kappe (12) ausgebildet sind, die senkrecht auf den flächigen Leitern (22, 44) des wenigstens einen Bezugspotentials steht.

5. Elektronische Einrichtung nach einem der vorhergehenden Ansprüche, **dadurch gekennzeichnet, dass** die Kappe aus Metall besteht.

6. Elektronische Einrichtung nach einem der Ansprüche 1 bis 4, **dadurch gekennzeichnet, dass** die Kappe (12) aus einem Kunststoff besteht, dem Metall- oder Kohlefasern zugesetzt sind.

7. Elektronische Einrichtung nach einem der Ansprüche 1 bis 4, **dadurch gekennzeichnet, dass** die Kappe im Bereich der flächigen Bereiche (30) sowie innenseitig und/oder außenseitig mit einer metallischen Beschichtung versehen ist.

8. Elektronische Einrichtung nach einem Ansprüche 1 bis 4, **dadurch gekennzeichnet, dass** die Kappe (12) wenigstens in den flächigen Bereichen (30) sowie innenseitig und/oder außenseitig mit einem leitfähigen Lack überzogen ist.

9. Elektronische Einrichtung nach einem der vorhergehenden Ansprüche, **dadurch gekennzeichnet, dass** zwischen der leitfähigen Kappe (12) und dem Leiter (49) eines Bezugspotentials eine galvanische Verbindung (46) vorgesehen ist.

10. Elektronische Einrichtung nach Anspruch 9, **dadurch gekennzeichnet, dass** die galvanische Verbindung durch einen an der Kappe (12) oder dem Leiter (44) des Bezugspotentials angeordneten leitfähigen Vorsprung (46) ausgebildet ist, der durch die elektrische Isolierung (32) ragt.

11. Elektronische Einrichtung nach einem der vorhergehenden Ansprüche, **dadurch gekennzeichnet, dass** die Leiter (22, 44) auf einer Leiterplatte angeordnet sind oder als metallische Schienen- oder Blechelemente zusammen mit einem Kunststoffträger (24) einen Leadframe bilden.

12. Elektronische Einrichtung nach Anspruch 11, **dadurch gekennzeichnet, dass** der Kunststoffträger (24) im Auflagebereich der flächigen Bereiche (30) der Kappe (12) durch Warmumlegen die elektrische Isolierung (32) zwischen den flächigen Bereichen der Kappe und des Leiters bildet.

13. Elektronische Einrichtung nach einem der vorhergehenden Ansprüche, **dadurch gekennzeichnet, dass** die elektrische Isolierung (32) zwischen den flächigen Bereichen (30, 42) eine relative Dielektrizitätskonstante mit einem Wert größer als 1 besitzt.

## Claims

1. Electronic device (10) with a screen (12) against radiofrequency electromagnetic fields, wherein the screen (12) consists of an at least partially conductive cap (12) surrounding the device (10), wherein conductive two-dimensional regions (30) of the cap are arranged electrically insulated at a short distance in parallel with at least one two-dimensional region (42) of a conductor (22, 44) of a reference potential so that a capacitive coupling of the cap (12) to the reference potential is produced, **characterized in that** the two-dimensional regions (30) of the cap interact with two-dimensional regions (42) of various conductors having different reference potentials.

2. Electronic device according to Claim 1, **characterized in that** the electrical insulation (32) between the two-dimensional regions (30, 42) is formed by an inserted foil.

3. Electronic device according to Claim 1, **characterized in that** the electrical insulation (32) is formed by a nonconductive coating of the two-dimensional regions (30) of the cap (12) and/or the two-dimensional regions (42) of associated conductors (22).

4. Electronic device according to one of the preceding claims, **characterized in that** the two-dimensional regions (30) of the cap (12) are formed on a front edge area (30) on the end of the cap (12), which is perpendicular to the two-dimensional conductors (22, 44) of the at least one reference potential.

5. Electronic device according to one of the preceding claims, **characterized in that** the cap consists of metal.

6. Electronic device according to one of Claims 1 to 4, **characterized in that** the cap (12) consists of a plastic to which metal or carbon fibers are added.

7. Electronic device according to one of Claims 1 to 4, **characterized in that** the cap is provided with a metallic coating in the area of the two-dimensional regions (30) and on the inside and/or the outside.

8. Electronic device according to one of Claims 1 to 4, **characterized in that** the cap (12) is coated with a conductive lacquer at least in the two-dimensional regions (30) and on the inside and/or the outside.

9. Electronic device according to one of the preceding claims, **characterized in that** a direct connection (46) is provided between the conductive cap (12) and the conductor (44) of a reference potential.

10. Electronic device according to Claim 9, **characterized in that** the direct connection is formed by a conductive projection (46) arranged at the cap (12) or the conductor (44) of the reference potential, which protrudes through the electrical insulation (32).

11. Electronic device according to one of the preceding claims, **characterized in that** the conductors (22, 44) are arranged on a circuit board or, as metallic rail or sheet-metal elements, together with a plastic carrier (24), form a leadframe.

12. Electronic device according to Claim 11, **characterized in that** the plastic carrier (24) forms the electrical insulation (32) between the two-dimensional regions of the cap and the conductor in the support area of the two-dimensional regions (30) of the cap (12) by hot fold-over.

13. Electronic device according to one of the preceding claims, **characterized in that** the electrical insulation (32) has a relative dielectric constant having a value of greater than 1 between the two-dimensional regions (30, 42).

## Revendications

1. Dispositif électronique (10) comportant un blindage (12) contre des champs électromagnétiques de haute fréquence, où le blindage (12) se compose d'un capot (12) au moins partiellement conducteur de l'électricité entourant le dispositif (10), où des parties (30) planes et conductrices du capot sont disposées en isolement électrique à faible distance parallèlement à une partie plane (42) d'un conducteur (22, 44) d'un potentiel de référence, si bien qu'il se produit un couplage capacitif entre le capot (12) et le potentiel de référence, **caractérisé par le fait que** les parties planes (30) du capot sont en interaction avec des parties planes (42) de différents conducteurs ayant divers potentiels de référence.

2. Dispositif électronique selon la revendication 1, **caractérisé par le fait que** l'isolement électrique (32) entre les parties planes (30, 42) est formé par un film intermédiaire.

3. Dispositif électronique selon la revendication 1, **caractérisé par le fait que** l'isolement électrique (32) est formé par un revêtement non conducteur des parties planes (30) du capot (12) et/ou des parties planes (42) des conducteurs correspondants.

4. Dispositif électronique selon l'une des revendications précédentes, **caractérisé par le fait que** les parties planes (30) du capot (12) sont ménagées sur une zone (30) faisant partie du bord du côté avant du capot (12), qui est perpendiculaire aux conducteurs plans (22, 44) du au moins un potentiel de référence.

5. Dispositif électronique selon l'une des revendications précédentes, **caractérisé par le fait que** le capot est en métal.

6. Dispositif électronique selon l'une des revendications 1 à 4, **caractérisé par le fait que** le capot est en matière plastique à laquelle sont ajoutées des fibres en métal ou en carbone.

7. Dispositif électronique selon l'une des revendications 1 à 4, **caractérisé par le fait que** le capot est doté d'un revêtement métallique dans la zone des parties planes (30), ainsi que sur la face intérieure et/ou la face extérieure.

8. Dispositif électronique selon l'une des revendications 1 à 4, **caractérisé par le fait que** le capot (12) est revêtu d'un vernis conducteur de l'électricité au moins dans les parties planes (30), ainsi que sur la face intérieure et/ou la face extérieure.

9. Dispositif électronique selon l'une des revendications précédentes, **caractérisé par le fait qu'**il est prévu une liaison galvanique entre le capot conducteur de l'électricité (12) et le conducteur (44) d'un potentiel de référence.

10. Dispositif électronique selon la revendication 9, **caractérisé par le fait que** la liaison galvanique est formée par une avancée (46) conductrice de l'électricité placée sur le capot (12) ou sur le conducteur (44) du potentiel de référence, laquelle avancée fait saillie à travers l'isolant (32) électrique.

11. Dispositif électronique selon l'une des revendications précédentes, **caractérisé par le fait que** les conducteurs (22, 44) sont disposés sur une carte à circuits imprimés ou forment, en tant qu'éléments de rails ou de tôles métalliques, en commun avec un support en matière plastique (24), une trame métallique (ou, en anglais, "leadframe").

12. Dispositif électronique selon la revendication 11, **caractérisé par le fait que** le support en matière plastique (24) forme par pliage à chaud, dans la zone d'application des parties planes (30) du capot (12), l'isolement électrique (32) entre les parties planes du capot et du conducteur.

13. Dispositif électronique selon l'une des revendications précédentes, **caractérisé par le fait que** l'isolement électrique (32) entre les parties planes (30, 42) a une constante diélectrique relative ayant une valeur supérieure à 1.
